# FASCICULE DE BREVET EUROPEEN

(11) **EP 1 159 628 B1**
(45) Date de publication et mention de la délivrance du brevet: **18.12.2002**
(21) Numéro de dépôt: 00909440.0
(22) Date de dépôt: 07.03.2000
(51) Int. Cl.: G01R 31/3185

(54) **PROCEDE DE TEST DE CIRCUITS INTEGRES AVEC ACCES A DES POINTS DE MEMORISATION DU CIRCUIT**
VERFAHREN ZUR PRÜFUNG VON INTEGRIERTEN SCHALTUNGEN MIT SPEICHERELEMENT-ZUGRIFF
METHOD FOR TESTING INTEGRATED CIRCUITS WITH MEMORY ELEMENT ACCESS

(30) Priorité: 08.03.1999 FR 9902823
(43) Date de publication de la demande: 05.12.2001
(73) Titulaire: FRANCE TELECOM, 75015 Paris (FR)
(72) Inventeur: BARTHEL, Dominique, F-38190 Bernin (FR)
(74) Mandataire: Texier, Christian
(86) Numéro de dépôt international: FR0000559
(87) Numéro de publication internationale: WO00054067

(56) Documents cités:
- US-A- 5 850 513

## Description

La présente invention concerne les procédés et les dispositifs pour tester les circuits intégrés ainsi que les circuits intégrés munis de moyens autorisant la réalisation de tests efficaces.

On connaît deux principaux procédés pour tester des circuits intégrés logiques complexes.

Un premier procédé, appelé « procédé de génération automatique de vecteurs de test par chemin complet de balayage », ou « full scan ATPG » en anglais, est couramment utilisé pour tester la fabrication de puces.

Ce procédé consiste à injecter sur des broches du circuit intégré des signaux connus et à prélever sur des broches de sortie les valeurs obtenues, pour les comparer à des valeurs attendues.

On utilise dans ce procédé un testeur dont des canaux sont reliés aux broches d'entrée-sortie du circuit intégré. Pour mettre en oeuvre correctement ce procédé, il faut un testeur ayant un nombre de canaux égal au nombre de broches d'entrée-sortie du circuit.

Avec ce procédé, on sait tester en particulier une fonction logique combinatoire. Connaissant la combinatoire, on sait générer automatiquement les vecteurs logiques qui permettent de vérifier de manière quasi-exhaustive l'implémentation correcte de la combinatoire.

Cependant, lorsque la fonction du circuit intégré comprend des éléments de mémorisation, on ne sait pas en général générer les vecteurs de test. Dans certains cas rares où l'on sait générer ces vecteurs malgré la présence de points de mémorisation, le nombre de vecteurs de test est très élevé, de sorte que l'on doit mettre en oeuvre une séquence de test très longue, difficile à stocker en mémoire, difficile à manipuler, et nécessitant beaucoup de temps sur testeur.

Pour éviter cet inconvénient dans le cas des circuits intégrés à points de mémorisation, on sait mettre en place dans le circuit un chemin d'accès aux points de mémorisation qui permet de lire et d'écrire sur tous ces points de mémorisation, de telle façon que la fonction du circuit intégré est réduite, en commandant les points de mémorisation, à une fonction combinatoire que l'on sait tester.

De manière courante, les points de mémorisation sont placés en série sur le chemin d'accès, ce chemin d'accès étant réservé au test. Ce chemin est appelé « chemin de balayage complet », ou « full scan path » en anglais. Ce chemin d'accès ajoute quelques entrées-sorties au circuit.

Ce premier procédé comporte un inconvénient majeur.

Il nécessite un accès physique, constitué par un canal du testeur, pour chaque entrée-sortie du circuit intégré. Or, de nos jours, le nombre d'entrées-sorties des circuits intégrés logiques dépasse couramment plusieurs centaines, et atteindra bientôt le millier, et les testeurs actuels ne peuvent être réalisés en pratique qu'avec quelques centaines de canaux. Les testeurs actuels deviennent donc inadaptés aux circuits intégrés à tester.

Plus généralement, les testeurs sont d'autant plus coûteux que leur nombre de canaux est élevé.

Cet inconvénient est particulièrement aigu dans le cas de circuits de grande taille, qui sont les plus susceptibles de présenter des défauts de fonctionnement. Pour de tels circuits, on réalise le test directement sur une tranche de silicium, avant un montage du circuit en boîtier, long et coûteux, qui pourrait s'avérer inutile du fait que le circuit risque d'être défectueux. Un tel test sur tranche se fait à l'aide d'une carte à pointes, dont le coût et la complexité de réalisation augmentent plus vite que le nombre de pointes, notamment en raison d'une contrainte de coplanarité des pointes.

Pour ces raisons, on met en oeuvre cette méthode ATPG en ne reliant qu'une partie des broches d'entrée-sortie au testeur. Certaines entrées-sorties restent donc non testées, au détriment de la qualité du test de fabrication, et des zones du circuit restent non testées.

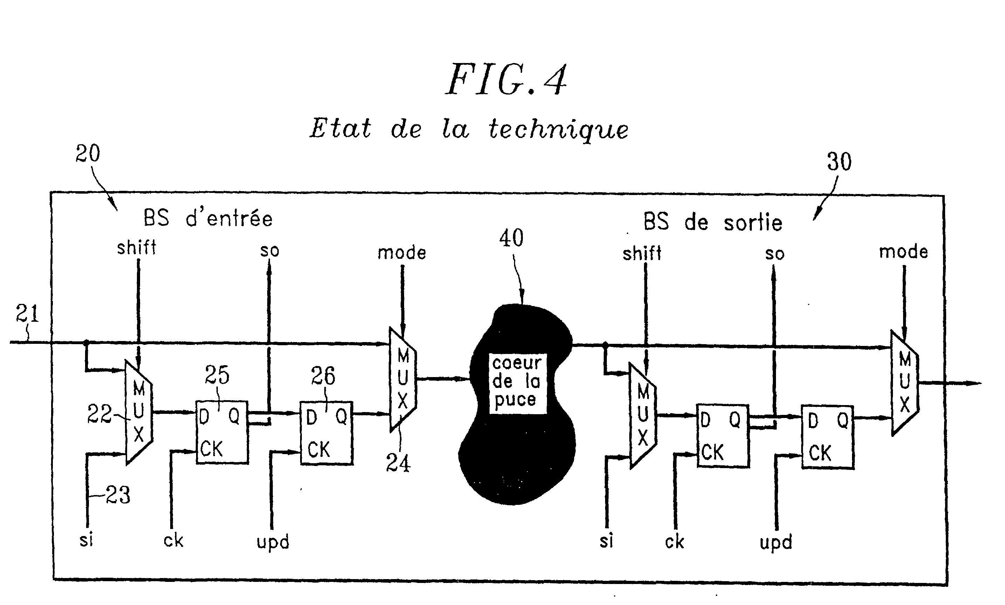

On a ainsi représenté, sur la figure 3, un circuit testé avec ce procédé connu, sur lequel sont indiquées par la référence 10 les branches non connectées, et sur lequel les zones non testées ont été hachurées.

On connaît un second procédé de test de circuits intégrés, qui permet le contrôle et l'observation de niveaux logiques sur les entrées-sorties d'un circuit, même quand les interconnections du boîtier ne sont pas accessibles physiquement. Ce procédé est utilisé notamment dans le cas d'un boîtier à bille monté en surface (boîtier BGA), ou encore dans le cas d'un circuit imprimé multi-couches.

Ce second type de test, appelé « JTAG Boundary scan » (balayage de la périphérie), et défini par le « Joint Test Action Group » , standard IEEE 1149.1, concerne essentiellement le test des cartes imprimées et des soudures des circuits intégrés sur ces cartes. Ce standard IEEE 1149.1 prévoit un chemin d'accès aux entrées/sorties apte à se substituer à une connexion physique directe sur les entrées/sorties.

Ce second type de test est mis en oeuvre en ajoutant dans le circuit intégré et dans la carte imprimée qui le porte une logique spécifique à ce test qui permet, sous le contrôle d'un automate appelé contrôleur TAP («Test Access Port controller » en anglais), de capturer le niveau logique présent sur une entrée, et/ou d'imposer le niveau logique sur une sortie du circuit intégré. En mode normal, cette logique est transparente, aussi bien pour les entrées que pour les sorties.

Ainsi, les circuits intégrés d'une carte sont munis d'un chemin d'accès ayant la forme d'un boucle et reliant en série l'ensemble des entrées/sorties du circuit considéré, et les boucles de chacun des circuits intégrés sont reliées en série.

La chaîne du Boundary Scan parcourt donc le composant auquel elle est intégrée, et parcourt également la carte recevant les composants. Une chaîne de Boundary Scan générale relie en série les chaînes de Boundary Scan de chaque composant, de sorte que chaque plot d'entrée/sortie de chaque composant ainsi que chaque piste de la carte est accessible depuis l'extérieur de la carte, par un même chemin depuis une borne spécifique de la carte, le transfert des données capturées ou à imposer s'effectuant en série dans ce chemin.

Par de telles dispositions, le Boundary Scan autorise également à tester les interconnexions entre les circuits intégrés sur une carte. Dans ce cas, le vecteur de test est chargé en série dans le chemin de Boundary scan, puis émis sur les interconnexions à tester via des tampons de sortie des composants. Les résultats sont échantillonnés dans le Boundary scan, via les entrées des composants, puis sortis en série vers le testeur.

Dans un mode « test interne », adapté pour tester les composants eux-mêmes, un vecteur de test est chargé en série dans le chemin de Boundary Scan puis appliqué à la logique interne du circuit intégré. Le résultat est échantillonné dans le Boundary Scan Path, puis lu en série par le testeur.

Ce second procédé de test présente des inconvénients : il est de mise en oeuvre particulièrement longue, notamment dans le mode interne où l'on teste les composants de la carte. De plus, ce procédé de test s'avère particulièrement inadapté au test des circuits intégrés avant leur montage, notamment pour tester les circuits intégrés comprenant des éléments de mémorisation.

On connaît également de US 5 850 513, un système permettant une vérification de données de fonctionnement d'un circuit, incluant un sous-système de maintenance, une mémoire flash, un contrôleur, une unité de traitement, un module mémoire principal, un réseau de chemin de données, des moyens formant bus dual, des moyens de contrôle logiques programmables, un buse de transfert auxiliaire de données, et une série de modules d'entrée/sortie.

L'ensemble de ces composants traite des blocs de données de microcodes. Les éléments tels qu'associés dans ce document, ne permet pas un test du circuit intégré sans connexions multiples. Ce document n'apporte donc pas de solution satisfaisante à la mise en oeuvre particulièrement longue des procédés de test habituels.

L'invention a pour but de résoudre ces différents inconvénients, en proposant un procédé de test de circuits intégrés ne nécessitant pas la connexion de toutes les entrées/sorties de ce circuit sur un testeur et permettant de tester une zone étendue, voire l'ensemble du circuit, ce procédé pouvant en outre être réalisé beaucoup plus rapidement que les procédés de test connus.

En d'autres termes, l'invention se propose d'améliorer la couverture d'un test de fabrication de circuit intégré par rapport à la méthode connue d'ATPG full-scan, sans augmenter le nombre de canaux du testeur.

Ces buts sont atteints selon l'invention grâce à un procédé pour tester un circuit intégré comprenant des points de mémorisation et une chaîne de Boundary Scan, dans lequel on écrit et/ou on lit sur les points de mémorisation par l'intermédiaire d'un chemin d'accès aux points de mémorisation depuis une borne extérieure du circuit, caractérisé en ce que l'on active la chaîne de Boundary Scan pour imposer et/ou observer des niveaux logiques sur les entrées/sorties du circuit intégré.

D'autres caractéristiques, buts et avantages de l'invention apparaîtront à la lecture de la description détaillée qui va suivre, en référence aux figures annexées sur lesquelles :

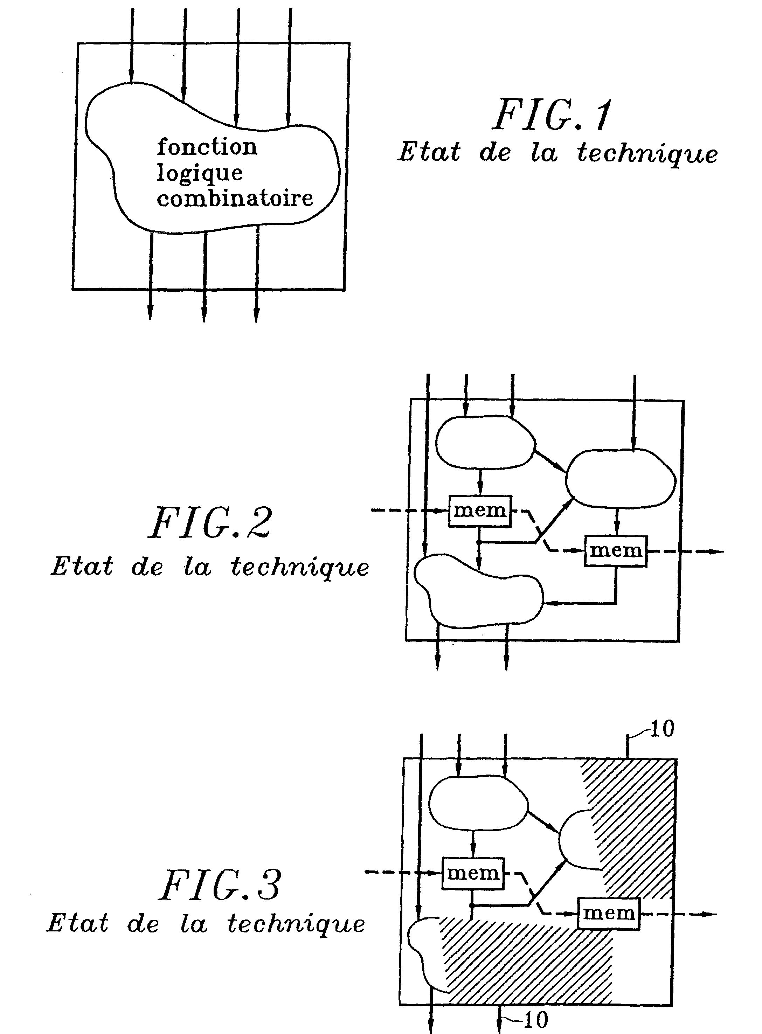

- la figure 1 représente schématiquement un circuit intégré purement combinatoire conforme à l'état de la technique ;
- la figure 2 représente un circuit intégré comportant des fonctions combinatoires et des éléments de mémorisation conforme à l'état de la technique ;
- la figure 3 représente le même circuit qu'à la figure 2, sur lequel on a indiqué par des zones hachurées des zones non testées en employant un procédé ATPG de l'état de la technique ;
- la figure 4 représente un circuit intégré muni d'une chaîne de Boundary Scan dont des entrées et sorties ont été représentées de manière détaillée, conforme à l'état de la technique ;
- la figure 5 représente un circuit intégré selon l'invention dont un chemin d'accès à des éléments de mémorisation a été concaténé à un chemin de Boundary Scan ;
- la figure 6 représente un circuit intégré selon l'invention, conforme à celui de la figure 5, et dont on a représenté les moyens de connexion entre le chemin d'accès aux éléments de mémorisation et le chemin de Boundary Scan.

Sur le circuit intégré de la figure 4, on a représenté trois parties principales : deux modules 20 et 30 d'entrée/sortie du Boundary Scan, et entre ces deux modules, une partie 40 formant le coeur du circuit intégré.

Les deux modules 20 et 30 représentés ici sont identiques l'un à l'autre.Chacun des deux modules 20 et 30 est placé en parallèle d'une liaison directe entre une broche de connection et le coeur 40 de la puce.

On décrira seulement le module 20, le module 30 comportant les mêmes éléments que le module 20.

Le module 20 présente deux extrémités, chacune formée par un multiplexeur 22, 24. Un premier 22 de ces deux multiplexeurs reçoit sur une liaison 23 un signal de commande appelé « signal shift », qui configure la cellule en « décalage » ou en « chargement ».

Dans le cas de la cellule 20 représentée à gauche sur la figure 4, le multiplexeur 22 est apte à recevoir sur sa première entrée 21 un signal de broche, qui est par exemple un signal reçu d'une autre puce de la carte

Sur une deuxième entrée 23 du multiplexeur 22, celui-ci reçoit un signal d'entrée SI, portant des données transférées dans la chaîne de Boundary Scan et destinées à être chargées par la cellule 20 si celle-ci est en mode « décalage ».

Entre les deux multiplexeurs 21 et 24, la cellule présente deux registres 25 et 26, dont l'un est un registre à décalage 25 qui délivre un signal de sortie SO destiné à être transité dans le Boundary Scan vers d'autres cellules d'entrée/sortie non représentées de la puce 40, ou encore vers d'autres puces.

Le registre à décalage 25 reçoit également un signal d'horloge noté ck et l'autre registre 26 reçoit un signal upd de mise à jour des verrous de sortie de la cellule 20, c'est à dire de mémoires de la cellule 20 aptes à former un niveau logique choisi de cette entrée ou de cette sortie du circuit intégré, lorsque cette cellule 20 est activée.

Le registre à décalage 25 délivre également un signal SO qui contient, pour certaines cellules, des informations relevées sur cette cellule et/ou représentatives de données enregistrées dans la cellule 20, éventuellement destinées à être analysées pour interpréter le test.

Sl est donc l'entrée des données en série, SO la sortie des données en série.

Le multiplexeur 24 situé à l'autre extrémité de la cellule 20, c'est à dire entre la cellule 20 et le coeur 40 de la puce, reçoit un signal « mode » apte à commander la cellule 20 pour que le signal transmis par la cellule 20 au coeur de la puce 40 ne soit pas le signal reçu sur la broche 21 mais le signal constitué par le contenu des verrous de la cellule 20.

Les signaux SI et SO transitent dans le circuit intégré, de cellule d'entrée/sortie en cellule d'entrée/sortie sur l'ensemble de la boucle de Boundary scan reliant en série ces entrées/sorties.

De manière connue, un tel circuit intégré comporte un contrôleur TAP, non représenté, dont le rôle est de générer les signaux de commande SHIFT, UPD, CK et MODE de la chaîne de Boundary Scan du circuit intégré.

Lors d'un test d'une carte le contrôleur TAP reçoit lui-même des signaux de commande circulant dans le chemin de Boundary scan de la carte. Ces signaux de commande transmettent au contrôleur TAP du circuit les instructions concernant des niveaux logiques à imposer sur certaines cellules de son circuit intégré. A l'inverse, le contrôleur TAP transmet lui aussi dans le chemin de Boundary scan des niveaux logiques relevés sur certaines cellules.

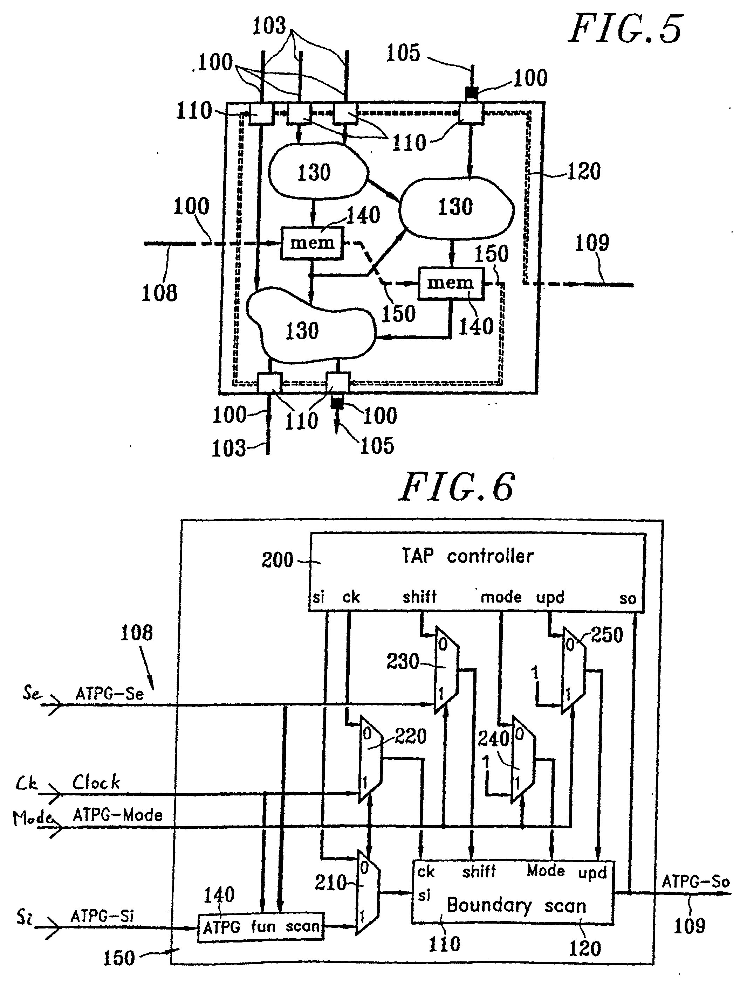

Le circuit intégré selon l'invention, qui est représenté à la figure 5, comporte un ensemble de broches 100, associées chacune à une cellule d'entrée/sortie 110. Les cellules 110 sont raccordées en série par un chemin périphérique 120 de Boundary Scan, représenté en double trait à tirets. Ce chemin périphérique 120 forme donc une boucle 110 qui parcourt le pourtour du circuit de cellule d'entrée/sortie 110 en cellule d'entrée/sortie 110.

Ce circuit intégré comporte des fonctions combinatoires 130 et des éléments de mémorisation 140. Les éléments de mémorisation 140 sont reliés entre eux en série par un chemin 150 qui permet d'accéder à ces mémoires depuis une broche extérieure 108. Ce chemin 150 permet de commander, lors d'un test, les mémoires 140 de manière directe depuis l'extérieur du circuit.

Parmi les broches 110, certaines broches référencées 103 sont reliées aux canaux d'un testeur non représenté et d'autres broches référencées 105 ne sont pas connectées au testeur. Les broches connectées 103 sont prolongées sur la figure 5 par un trait gras, tandis que les broches non connectées 105 ne sont munies que d'un court trait fin.

Conformément à l'invention, le test de ce circuit intégré est réalisé en agissant depuis l'extérieur sur les mémoires 140, tout en activant le chemin 120 de Boundary Scan.

On utilise le chemin 150 ou bien pour placer les mémoires 140 dans un état prédéterminé, ou bien pour relever leur état au cours du test. Simultanément, on utilise le chemin 120 de Boundary scan pour imposer sur certaines entrées/sorties non connectés 105 les niveaux logiques prédéterminés ou pour relever des niveaux logiques à observer.

Ainsi, on agit sur les mémoires 140 par l'intermédiaire du chemin 150 et on agit sur les cellules 105 non connectées par l'intermédiaire du chemin de Boundary Scan 120.

Dans ce mode de mise en oeuvre de l'invention, on injecte dans les broches connectées 103 des signaux choisis directement par les canaux du testeur.

Le chemin de Boundary Scan 120 étant connecté au testeur, le testeur envoie dans ce chemin un signal choisi spécifiquement pour activer certaines des autres cellules 105 qui sont non connectées et pour leur imposer un niveau logique prédéterminé.

En utilisant à la fois le chemin de Boundary Scan 120 et à la fois une connexion directe des broches 103, le testeur a accès à toutes les broches 100 du circuit intégré. On peut donc appliquer tout vecteur de test souhaité sur un ensemble de broches qui englobe des broches connectées 103 et des broches non connectées 105.

On applique des niveaux prédéterminés à des groupes de broches d'entrée/sortie 100 en combinant une action par connexion directe sur certaines broches à une action indirecte sur les entrées-sorties par l'intermédiaire du Boundary Scan 120.

L'invention prévoit également de n'agir directement sur aucune broche et de n'imposer ou lire les niveaux logiques des entrées/sorties que par l'intermédiaire du Boundary Scan, tout en agissant directement sur les éléments de mémoire 140 du circuit par un ou plusieurs accès directs à ces mémoires 140.

Dans le cas d'un circuit à quinze éléments de mémoire par exemple, on peut adopter quinze chemins d'accès directs à chacune des mémoires, le Boundary Scan formant un seizième chemin de commande d'éléments du circuit. Bien entendu, il est également possible de placer quinze éléments de mémoire en série sur un même chemin comme dans le cas de la figure 5.

Sur l'exemple de réalisation de la figure 5, le chemin d'accès 150 aux éléments de mémoire 140 est concaténé au chemin de Boundary Scan 120 de sorte que ces deux chemins forment une même chaîne sur laquelle sont placés en série à la fois les éléments de mémoire 140 et les cellules d'entrée/sortie 110.

Ainsi, on agit sur les points de mémorisation 140 et sur les cellules d'entrée/sortie 110 avec la seule connexion 108 extérieure au circuit, en injectant les données en série dans cette chaîne.

A la figure 6, on a représenté un montage adapté à une telle concaténation de la chaîne de Boundary Scan 120 et de la chaîne 150 d'accès direct aux mémoires 140. Ce montage préférentiel présente l'avantage de laisser le chemin de Boundary Scan 120 disponible au contrôleur TAP en dehors d'une mise en oeuvre du procédé de test selon l'invention et de permettre, lors d'un test du circuit intégré réalisé conformément à l'invention, d'activer le chemin de Boundary Scan 120.

Pour cela, la chaîne d'accès 150 aux mémoires 140 est reliée à la chaîne de Boundary Scan 120 par l'intermédiaire d'au moins un multiplexeur commandé par un signal de mode ATPG-mode, injecté depuis la broche 108.

De manière classique, la chaîne de Boundary Scan 120 comprend six liaisons. On a schématisé, sur la figure 6, le chemin de Boundary Scan 120 par un simple rectangle muni de six connexions correspondant à ces liaisons.

De même, on a représenté l'ensemble formé du chemin d'accès 150 avec ses éléments de mémorisation 140 par un simple rectangle référencé 150.

On a représenté de façon détaillée la jonction entre la partie de chaîne de Boundary scan comprenant les cellules 110 en série, le contrôleur TAP 200, et le chemin d'accès 140 qui est appelé également ici chemin d'ATPG full scan par référence à l'art antérieur.

Ce raccordement est situé en aval du contrôleur TAP 200 sur la chaîne de Boundary Scan et en aval des points de mémorisation 140 sur le chemin d'accès 150.

Dans ce montage, la broche 108 forme l'extrémité extérieure d'un ensemble de quatre liaisons circulant parallèlement les unes aux autres sur le chemin 150 jusqu'à cette jonction.

Ces quatre liaisons sont :
- une liaison ATPG-si apte à transmettre un signal porteur d'informations aux éléments de mémorisation 140 et aux cellules 110, commandant des états de certaines mémoires 140 ou des niveaux logiques de certaines entrées/sorties 110 qui sont aptes à reconnaître les signaux qui leur sont destinés spécifiquement. Ce canal ATPG-si porte entre la broche 108 et sa jonction avec la chaîne de Boundary Scan les éléments de mémoire 140 disposés en série ;
- une liaison ATPG-se apte à transmettre au Boundary Scan un signal de mise en configuration de « décalage » ou de « chargement » SE de cellules choisies du Boundary Scan ;
- une liaison CLOCK apte à transporter un signal d'horloge CK jusqu'aux différents éléments du Boundary Scan, et ;
- une liaison ATPG-mode apte à véhiculer un signal de commande MODE indiquant si le Boundary Scan 120 est à relier au contrôleur 200 ou bien à la chaîne d'accès aux mémoires 150. Dans ce dernier cas, la chaîne de Boundary Scan 120 est reliée en série à la chaîne ATPG 150.

La liaison ATPG-mode est reliée à cinq multiplexeurs (ou fonctions équivalentes) dont elle constitue à chaque fois un canal de commande.

Un premier multiplexeur 210 reçoit sur une première entrée le signal SI véhiculé sur la liaison ATPG-Si et reçoit sur une seconde entrée un signal d'entrée Sl provenant du contrôleur TAP 200.

Un deuxième multiplexeur 220 reçoit sur ses deux entrées respectivement le signal d'horloge CK venant de la broche 108 et un autre signal d'horloge CK venant du contrôleur 200.

Un troisième multiplexeur 230 reçoit sur ses entrées respectivement le signal SE provenant de la broche 108 et le signal SHIFT venant du contrôleur 200.

Un quatrième multiplexeur 240 reçoit sur ses deux entrées respectivement le signal mode provenant du contrôleur 200 et un signal d'activation constant noté « 1 ».

Un cinquième multiplexeur 250 reçoit sur ses deux entrées respectivement le signal de mise à jour UPD provenant du contrôleur 200 et un signal d'activation constant noté « 1 ».

Lorsque le signal de mode qui est injecté dans la broche 108 sur la liaison ATPG-mode est à 0, les liaisons SI, MODE, Shift, CK et UPD du Boundary Scan 120 sont reliées, comme dans un circuit ordinaire, au contrôleur 200.

En d'autres termes, lorsqu'aucun signal de mode test activé n'est transmis dans la broche 108, le Boundary Scan 120 est relié à son dispositif de commande 200 prévu pour réaliser un test Boundary Scan courant.

Par contre, lorsqu'un signal d'activation de test est transmis sur le canal ATPG-mode de la broche 108, les canaux SI, CK, SHIFT du Boundary Scan 120 sont reliés respectivement aux signaux SI, CK, SE appliqués respectivement sur les liaisons ATPG-Si, Clock et ATPG-Se de la broche 108, tandis que les liaisons MODE et UPD du Boundary Scan 120 sont reliées aux valeurs constantes d'activation égales à 1.

Ainsi, lorsque la liaison ATPG-mode de la broche 108 reçoit un signal d'activation, le chemin de Boundary Scan 120 et les cellules 110 qu'il comprend sont commandés par les signaux SI, CK, et SE appliqués à la broche 108 depuis l'extérieur.

Dans ce même cas, le signal MODE et le signal UPD reçus par la chaîne de Boundary Scan 120 sont les signaux permanents d'activation de sorte que le contenu des verrous des cellules d'entrée/sortie du Boundary Scan est substitué aux signaux normalement prélevés sur les broches de ces cellules pendant le test selon l'invention.

On notera que le chemin d'accès 150 aux mémoires 140 est relié en permanence à l'entrée d'horloge de la broche 108, contrairement au Boundary Scan 120 qui est assujetti au signal d'horloge du contrôleur 200 ou de la broche 108 selon le contenu du signal de mode appliqué à la broche 108.

La sortie de la chaîne de Boundary Scan 120 forme une broche 109 et porte également une liaison reliant cette broche 109 au contrôleur 200, de sorte que sur le contrôleur 200 est rebouclé le signal de sortie SO du Boundary Scan 120.

Lors du test selon l'invention, un testeur connecté aux entrées ATPG-Se, Clock, ATPG-mode et ATPG-Si de la broche 108 active la chaîne concaténée comprenant les mémoires 140 en série avec les cellules 110, et applique un état choisi aux mémoires 140, impose un signal choisi sur des entrées/sorties 100 choisies du circuit intégré par l'intermédiaire de la chaîne de Boundary Scan, et relève des signaux obtenus sur des entrées/sorties 100 du circuit intégré par l'intermédiaire de la chaîne de Boundary Scan 120, ainsi que sur la broche 109.

On utilise donc lors du test du circuit intégré une logique présente dans le circuit et utilisée jusqu'à présent pour accéder à des entrées/sorties du circuit non accessibles en particulier lorsque ce circuit était monté sur une carte. On augmente donc la couverture du test d'un circuit intégré logique complexe ayant de nombreuses entrées/sorties.

Quelques portes logiques supplémentaires sont ajoutées au circuit pour raccorder la chaîne de Boundary Scan 120 à la chaîne ATPG full-scan, la mettre en mode non transparent et raccorder son horloge à l'horloge de test ATPG lorsque le test selon l'invention est mis en oeuvre.

Le testeur est avantageusement muni de quelques canaux branchés directement sur des broches d'entrée/sortie 100 du circuit.

Le testeur comporte alors un module pour injecter directement dans des entrées-sorties reliées à ces canaux des signaux de test et pour recevoir des signaux sortant de ces entrées-sorties 100, et pour les comparer à des signaux attendus. Le testeur comporte alors un dispositif de commande de la chaîne de Boundary Scan 120 du circuit intégré qui est coordonné au module d'injection/réception directe pour générer des vecteurs de test sur des ensembles comprenant à la fois des entrées-sorties 103 connectées directement au testeur et à la fois des entrées-sorties 105 connectées au testeur via la chaîne de Boundary Scan 120.

Dans le cas d'une telle association d'injections directes et d'injections par l'intermédiaire de la chaîne de Boundary Scan, le test permet de tester l'ensemble des parties du circuit et s'avère particulièrement rapide, efficace, du fait notamment que l'on utilise un testeur qui présente un nombre de canaux acceptable et permet un test rapide et plus complet du circuit.

Le fait d'injecter des vecteurs de test par l'association d'une injection directe dans les broches et d'une injection par l'intermédiaire de la chaîne de Boundary Scan peut même être adopté sans recourir à une intervention sur les points de mémorisation.

Le fait de concaténer les chaînes ATPG 150 et Boundary Scan 120 permet plus généralement d'agir sur les mémoires 140 et sur les cellules d'entrée/sortie 110 par une même entrée 108, avec un même générateur de signaux.

Grâce à l'invention on augmente le nombre de points de contrôle et d'observation, et donc on améliore la couverture de test au voisinage des entrées-sorties laissées non connectées.

L'invention améliore la testabilité au voisinage des entrées-sorties bidirectionnelles, même celles connectées à un canal du testeur, car elle fournit un accès de test à un point intermédiaire qui selon la norme IEEE 1149.1 doit faire partie de la chaîne de Boundary Scan, à savoir le signal de direction.

## Revendications

1. Procédé pour tester un circuit intégré comprenant des points de mémorisation (140) et une chaîne de Boundary Scan (120), dans lequel on écrit et/ou on lit sur les points de mémorisation (140) par l'intermédiaire d'un chemin d'accès (150) aux points de mémorisation (140) depuis une borne extérieure (108) du circuit, **caractérisé en ce que** l'on active la chaîne de Boundary Scan (120) pour imposer et/ou observer des niveaux logiques sur les entrées/sorties (110) du circuit intégré.

2. Procédé selon la revendication 1, **caractérisé en ce que** le chemin d'accès (150) aux points de mémorisation (140) et la chaîne de Boundary Scan (120) sont activés simultanément.

3. Procédé selon la revendication 1 ou 2, caractétisé en ce que le chemin d'accès (150) aux points de mémorisation (140) et la chaîne de Boundary Scan sont activés par l'intermédiaire d'une ligne comprenant en sèrie le chemin d'accès (150) aux points de mémorisation (140) et la chaîne de Boundary Scan (120).

4. Procédé selon l'une quelconque des revendications 1 à 3, **caractérisé en ce que** l'on active la chaine de Boundary Scan (120) par l'intermédiaire d'un chemin d'activation (150) relié à la chaîne de Boundary Scan (120) en aval d'un contrôleur TAP (200).

5. Procédé selon la revendication 4, **caractérisé en ce que** le chemin d'activation (150) est relié à la chaîne de Boundary Scan (120) au moins par une porte logique (210, 220, 230, 240, 250) apte à relier, en foriction d'un signal de commande (ATPG-mode), la chaine de Boundary Scan (120) ou bien au chemin d'activation (150) du Boundary Scan, ou bien au contrôleur TAP (200).

6. Procédé selon l'une des revendications 4 ou 5, **caractérisé en ce que** le chemin d'activation (150) inclut au moins un canal (ATPG-Si) sur lequel est placé au moins un point de mémorisation (140), ce canal étant apte à être relié en série avec la chaîne de Boundary Scan (120) lorsque celle-ci est activée.

7. Procédé selon l'une des revendications précédentes, **caractérisé en ce que** les canaux d'entrée (Si), d'horloge (ck) et de configuration (Sh) de la chaîne de Boundary Scan (120) sont reliés à des portes logiques (210, 220, 230, 240, 250) qui sont aptes à relier, selon un signal de commande (ATPG-Mode), ces canaux (Si, ck, Sh) ou bien aux canaux d'entrée (Si), d'horloge (ck) et de configuration (Sh) du contrôleur TAP (200) ou bien aux canaux d'entrée (Si), d'horloge (ck) et de configuration (Sh) du chemin d'activation (150).

8. Procédé selon l'une des revendications précédentes, **caractérisé en ce que** tous les points de mémorisation (140) sont reliés en série.

9. Procédé selon l'une des revendications précédentes, **caractérisé en ce qu'**au moins une partie des entrées/sorties (110) du circuit intégré est connectée directement à un testeur apte à injecter directement dans certaines de ces entrées/sorties (110) des signaux choisis, et/ou à recevoir directement de certaines de ces entrées/sorties (110) des signaux de sortie et à comparer ces signaux de sortie à des signaux attendus.

10. Procédé selon l'une des revendications précédentes en combinaison avec la revendication 9, **caractérisé en ce que** le testeur d'injection et/ou de mesure directe est coordonné à un dispositif de commande de la chaîne de Boundary Scan (120) pour générer des vecteurs de test sur des ensembles comprenant à la fois des entrées/sorties (103) connectés directement au testeur et à la fois des entrée/sorties (105) connectées au testeur via la chaîne de Boundary Scan (120).

11. Procédé selon l'une des revendications précédentes, **caractérisé en ce que** le circuit comporte des accès (150) à l'ensemble de ses points de mémorisation (140) et **en ce que** le test est réalisé en commandant l'ensemble des points de mémorisation (140) de sorte que la fonction du circuit intégré se réduit à une fonction combinatoire.

12. Circuit intégré comportant une chaîne de Boundary Scan (120) et un chemin d'accès (150) à au moins un point de mémorisation (140), **caractérisé en ce que** le chemin d'accès (150) et la chaîne de Boundary Scan (120) sont reliés en série et **en ce que** le circuit comporte des moyens (220,230,240,250) pour intervenir simultanément sur le ou les points de mémorisation (140) du chemin d'accès (150) et sur les cellules (110) de la chaîne de Boundary Scan (120).

13. Circuit intégré selon la revendication 12, **caractérisé en ce que** les moyens (220,230,240,250) pour intervenir simultanément sur le ou les points de mémorisation (140) du chemin d'accès (150) et sur les cellules (110) de la chaîne de Boundary Scan (120) comprennent au moins une porte logique (220,230,240,250) apte à relier la chaîne de Boundary Scan (120) ou bien au chemin d'accès (150), ou bien à un contrôleur TAP (200).

14. Circuit intégré selon la revendication 12 ou 13, **caractérisé en ce que** les canaux d'entrée (SI), d'horloge (CK) et de configuration (SHIFT) de la chaîne de Boundary Scan (120) sont reliés à des portes logiques (220,230,240,250) qui sont aptes à relier, selon un signal de commande (MODE), ces canaux ou bien aux canaux d'entrée (SI), d'horloge (CK) et de configuration (SHIFT) du contrôleur TAP (200), ou bien aux canaux d'entrée(ATPG_si), d'horloge (ATPG_ck) et de configuration (ATPG_se) du chemin d'accès (150).

15. Circuit intégré selon l'une des revendications 12 à 14, **caractérisé en ce que** tous les points de mémorisation (140) du circuit intégré sont reliés en série.

16. Testeur de circuit intégré, comprenant un premier module pour imposer et/ou lire des états de points de mémorisation (140) d'un circuit intégré, **caractérisé en ce qu'**il comporte un second module pour imposer des états et/ou lire des états de cellules d'entrée/sortie (110) par l'intermédiaire de la chaîne de Boundary Scan (120) du circuit simultanément à l'action du premier module.

17. Testeur de circuit intégré selon la revendication 16, **caractérisé en ce qu'**il est prévu pour injecter simultanément dans un circuit intégré des signaux de commande (SI) des points de mémorisation (140) et des signaux de commande (SI) des entrées/sorties (110) du Boundary Scan (120).

18. Testeur selon la revendication 17, **caractérisé en ce qu'**il est prévu pour injecter les signaux de commande (51) des points de mémorisation (140) et les signaux de commande (51) des entrées/sorties (110) du Boundary Scan (120) sur un même canal.

19. Testeur selon l'une quelconque des revendications 16 à 18, **caractérisé en ce qu'**il comporte une série de canaux aptes à être connectés directement à des entrées/sorties (103) d'un circuit intégré, et un module apte à injecter directement dans certaines de ces entrées/sorties (103) des signaux choisis, et/ou à recevoir des signaux de sortie de ces entrées/sorties (103, 109) pour comparer ces signaux de sortie à des signaux attendus.

20. Testeur selon la revendication 19, **caractérisé en ce qu'**il comporte un dispositif de commande de la chaîne de Boundary Scan (120) d'un circuit intégré coordonné au module d'injection/réception directe pour générer des vecteurs de test sur des ensembles comprenant à la fois des entrées-sorties (103) connectées directement au testeur et à la fois des entrées-sorties (105) connectées au testeur via la chaîne de Boundary Scan (120).

21. Testeur selon l'une des revendications 16 à 20, **caractérisé en ce qu'**il est apte à commander l'ensemble des points de mémorisation (140) de telle sorte que la fonction du circuit intégré se réduit à une fonction combinatoire pendant le test.

## Claims

1. Process for testing an integrated circuit comprising memory points (140) and a Boundary Scan chain (120), in which one writes and/or reads to and/or from the memory points (140) by way of an access path (150) to the memory points (140) from an outside terminal (108) of the circuit, **characterized in that** the Boundary Scan chain (120) is activated so as to impose and/or observe logic levels on the inputs/outputs (110) of the integrated circuit.

2. Process according to Claim 1, **characterized in that** the access path (150) to the memory points (140) and the Boundary Scan chain (120) are activated simultaneously.

3. Process according to Claim 1 or 2, **characterized in that** the access path (150) to the memory points (140) and the Boundary Scan chain are activated by way of a line comprising in series the access path (150) to the memory points (140) and the Boundary Scan chain (120).

4. Process according to any one of Claims 1 to 3, **characterized in that** the Boundary Scan chain (120) is activated by way of an activation path (150) linked to the Boundary Scan chain (120) downstream of a TAP controller (200).

5. Process according to Claim 4, **characterized in that** the activation path (150) is linked to the Boundary Scan chain (120) at least by a logic gate (210, 220, 230, 240, 250) able to link, as a function of a control signal (ATPG-mode), the Boundary Scan chain (120) either to the activation path (150) of the Boundary Scan, or to the TAP controller (200).

6. Process according to either of Claims 4 and 5, **characterized in that** the activation path (150) includes at least one channel (ATPG-Si) on which is placed at least one memory point (140), this channel being able to be linked in series with the Boundary Scan chain (120) when the latter is activated.

7. Process according to one of the preceding claims, **characterized in that** the input channel (Si), clock channel (ck) and configuration channel (Sh) of the Boundary Scan chain (120) are linked to logic gates (210, 220, 230, 240, 250) which are able to link, according to a control signal (ATPG-mode), these channels (Si, ck, Sh) or else to the input channel (Si), clock channel (ck) and configuration channel (Sh) of the TAP controller (200) or else to the input channel (Si), clock channel (ck) and configuration channel (Sh) of the activation path (150).

8. Process according to one of the preceding claims, **characterized in that** all the memory points (140) are linked in series.

9. Process according to one of the preceding claims, **characterized in that** at least some of the inputs/outputs (110) of the integrated circuit are connected directly to a tester able to inject chosen signals directly into certain of these inputs/outputs (110), and/or to receive output signals directly from certain of these inputs/outputs (110) and to compare these output signals with expected signals.

10. Process according to one of the preceding claims in combination with Claim 9, **characterized in that** the injection and/or direct measurement tester is coordinated with a device for controlling the Boundary Scan chain (120) so as to generate test vectors on sets comprising both inputs/outputs (103) connected directly to the tester and also inputs/outputs (105) connected to the tester via the Boundary Scan chain (120).

11. Process according to one of the preceding claims, **characterized in that** the circuit comprises accesses (150) to its set of memory points (140) and **in that** the test is carried out by controlling the set of memory points (140) so that the function of the integrated circuit is reduced to a combinatorial function.

12. Integrated circuit comprising a Boundary Scan chain (120) and an access path (150) to at least one memory point (140), **characterized in that** the access path (150) and the Boundary Scan chain (120) are linked in series and **in that** the circuit comprises means (220, 230, 240, 250) for intervening simultaneously on the memory point or points (140) of the access path (150) and on the cells (110) of the Boundary Scan chain (120).

13. Integrated circuit according to Claim 12, **characterized in that** the means (220, 230, 240, 250) for intervening simultaneously on the memory point or points (140) of the access path (150) and on the cells (110) of the Boundary Scan chain (120) comprise at least one logic gate (220, 230, 240, 250) able to link the Boundary Scan chain (120) or else to the access path (150), or else to a TAP controller (200).

14. Integrated circuit according to Claim 12 or 13, **characterized in that** the input channel (SI), clock channel (CK) and configuration channel (SHIFT) of the Boundary Scan chain (120) are linked to logic gates (220, 230, 240, 250) which are able to link, according to a control signal (MODE), these channels or else to the input channel (SI), clock channel (CK) and configuration channel (SHIFT) of the TAP controller (200), or else to the input channel (ATPG_si), clock channel (ATPG_ck) and configuration channel (ATPG_se) of the access path (150).

15. integrated circuit according to one of Claims 12 to 14, **characterized in that** all the memory points (140) of the integrated circuit are linked in series.

16. Integrated circuit tester, comprising a first module for imposing and/or reading states of memory points (140) of an integrated circuit, **characterized in that** it comprises a second module for imposing states and/or reading states of input/output cells (110) by way of the Boundary Scan chain (120) of the circuit simultaneously with the action of the first module.

17. Integrated circuit tester according to Claim 16, **characterized in that** it is contrived so as to simultaneously inject into an integrated circuit, control signals (SI) for the memory points (140) and control signals (SI) for the inputs/outputs (110) of the Boundary Scan (120).

18. Tester according to Claim 17, **characterized in that** it is contrived so as to inject the control signals (51) for the memory points (140) and the control signals (51) for the inputs/outputs (110) of the Boundary Scan (120) onto one and the same channel.

19. Tester according to any one of Claims 16 to 18, **characterized in that** it comprises a series of channels able to be connected directly to inputs/outputs (103) of an integrated circuit, and a module able to inject chosen signals directly into certain of these inputs/outputs (103), and/or to receive output signals from these inputs/outputs (103, 109) so as to compare these output signals with expected signals.

20. Tester according to Claim 19, **characterized in that** it comprises a control device for the Boundary Scan chain (120) of an integrated circuit coordinated with the direct injection/reception module so as to generate test vectors on sets comprising both inputs/outputs (103) connected directly to the tester and also inputs/outputs (105) connected to the tester via the Boundary Scan chain (120).

21. Tester according to one of Claims 16 to 20, **characterized in that** it is able to control the set of memory points (140) in such a way that the function of the integrated circuit is reduced to a combinatorial function during the test.

## Patentansprüche

1. Verfahren zum Testen einer integrierten Schaltung, die Speicherstellen (140) und eine Boundary Scan Chain (120) umfaßt, in die geschrieben wird und/oder gelesen wird auf den Speicherscellen (140) mittels eines Zugriffspfades (150) zu den Speicherstellen (140) von einem Außenanschluß (108) der Schaltung, **dadurch gekennzeichnet, daß** die Boundary Scan Chain (120) aktiviert wird, um logische Pegel an den Eingängen/Ausgängen (110) der integrierten Schaltung anzulegen und/oder zu beobachten.

2. Verfahren nach Anspruch 1, **dadurch gekennzeichnet, daß** der Zugriffspfad (150) zu den Speicherstellen (140) und die Boundary Scan Chain (120) gleichzeitig aktiv sind.

3. Verfahren nach Anspruch 1 oder 2, **dadurch gekennzeichnet, daß** der Zugriffspfad (150) zu den Speicherstellen (140) und die Boundary Scan Chain mittels einer Leitung aktiviert werden, die in Serie den Zugriffspfad (150) zu den Speicherstellen (140) und die Boundary Scan Chain (120) umfaßt.

4. Verfahren nach einem der Ansprüche 1 bis 3, **dadurch gekennzeichnet, daß** die Boundary Scan Chain (120) mittels eines Aktivierungspfades (150) aktiviert wird, der mit der Boundary Scan Chain (120) stromab einer TAP-Steuerung (200) verbunden ist.

5. Verfahren nach Anspruch 4, **dadurch gekennzeichnet, daß** der Aktivierungspfad (150) mit der Boundary Scan Chain (120) wenigstens über ein logisches Gatter (210, 220, 230, 240, 250) verbunden ist, das geeignet ist, abhängig von einem Steuersignal (ATPG-Modus) die Boundary Scan Chain (120) entweder mit dem Aktivierungspfad (150) der Boundary Chain oder mit der TAP-Steuerung (200) zu verbinden.

6. Verfahren nach einem der Ansprüche 4 oder 5, **dadurch gekennzeichnet, daß** der Aktivierungspfad (150) wenigstens einen Kanal (ATPG-Si) aufweist, auf dem wenigstens eine Speicherstelle (140) angeordnet ist, wobei dieser Kanal geeignet ist, in Serie mit der Boundary Scan Chain (120) verbunden zu werden, wenn diese aktiviert ist.

7. Verfahren nach einem der vorhergehenden Ansprüche, **dadurch gekennzeichnet, daß** die Eingangs- (Si), Takt- (ck) und Konfigurations-Kanäle (Sc) der Boundary Scan Chain (120) mit logischen Gattern (210, 220, 230, 240, 250) verbunden sind, die geeignet sind, gemäß einem Steuersignal (ATPG-Modus) diese Signale (Si, ck, Sh) entweder mit den Eingangs- (Si), Takt- (ck) und Konfigurations-Kanälen (Sh) der Steuerung TAP (200) oder mit den Eingangs- (Si), Takt- (ck) und Konfigurations-Kanälen (Sh) des Aktivierungspfades (150) zu verbinden.

8. Verfahren nach einem der vorhergehenden Ansprüche, **dadurch gekennzeichnet, daß** alle Speicherstellen (140) in Serie geschaltet sind.

9. Verfahren nach einem der vorhergehenden Ansprüche, **dadurch gekennzeichnet, daß** wenigstens ein Teil der Eingänge/Ausgänge (110) der integrierten Schaltung direkt mit einem Testgerät verbunden ist, das geeignet ist, ausgewählte Signale direkt in einige dieser Eingänge/Ausgänge (110) einzugeben, und/oder Ausgangssignale direkt von einigen dieser Eingänge/Ausgänge (110) zu empfangen und diese Ausgangssignale mit erwarteten Signalen zu vergleichen.

10. Verfahren nach einem der vorhergehenden Ansprüche, in Kombination mit Anspruch 9, **dadurch gekennzeichnet, daß** das Testgerät zum direkten Eingeben und/oder direkten Messen einer Steuervorrichtung der Boundary Scan Chain (120) zum Erzeugen von Testvektoren auf Mengen zugeordnet ist, die zugleich mit dem Testgerät direkt verbundene Eingänge/Ausgänge (103) und zugleich mit dem Testgerät über die Boundary Scan Chain (120) verbundene Eingänge/Ausgänge (105) umfassen.

11. Verfahren nach einem der vorhergehenden Ansprüche, **dadurch gekennzeichnet, daß** die Schaltung Zugriff (150) auf die Menge ihrer Speicherstellen (140) aufweist, und daß der Test unter Steuerung der Menge an speicherstellen (140) derart durchgeführt wird, daß die Funktion der integrierten Schaltung sich auf eine kombinatorische Funktion reduziert.

12. Integrierte Schaltung, die eine Boundary Scan Chain (120) und einen Zugriffspfad (150) zu wenigstens einer Speicherstelle (140) umfaßt, **dadurch gekennzeichnet, daß** der Zugriffspfad (150) und die Boundary Scan Chain (120) in Serie geschaltet sind, und daß die Schaltung Mittel (220, 230, 240, 250) zum gleichzeitigen Eingreifen in die Speicherstelle(n) (140) des Zugriffspfades (150) und in die Zellen (110) der Boundary Scan Chain (120) aufweist.

13. Integrierte Schaltung nach Anspruch 12, **dadurch gekennzeichnet, daß** die Mittel (220, 230, 240, 250) zum gleichzeitigen Eingreifen in die Speicherstelle(n) (140) des Zugriffspfades (150) und in die Zellen (110) der Boundary Scan Chain (120) wenigstens ein logisches Gatter (220, 230, 240, 250) umfassen, das geeignet ist, die Boundary Scan Chain (120) entweder mit dem Zugriffspfad (150) oder mit einer TAP-Steuerung (200) zu verbinden.

14. Integrierte Schaltung nach Anspruch 12 oder 13, **dadurch gekennzeichnet, daß** die Eingangs- (Si), Takt- (CK) und Konfigurations-Kanäle (SHIFT) der Boundary Scan Chain (120) mit logischen Gattern (220, 230, 240, 250) verbunden sind, die geeignet sind, gemäß einem Steuersignal (MODE) diese Kanäle entweder mit den Eingangs- (SI), Takt- (CK) und Konfigurations-Kanälen (SHIFT) der TAP-Steuerung (200) oder mit den Eingangs- (ATPG_si), Takt- (ATPG_ck) und Konfigurations-Kanälen (ATPG_se) des Zugriffspfades (150) zu verbinden.

15. Integrierte Schaltung nach einem der Ansprüche 12 bis 14, **dadurch gekennzeichnet, daß** alle Speichersteilen (140) der integrierten Schaltung in Serie geschaltet sind.

16. Testgerät für integrierte Schaltungen, das ein erstes Modul zum Anlegen und/oder Lesen von Zuständen von Speicherstellen (140) einer integrierten Schaltung umfaßt, **dadurch gekennzeichnet, daß** es ein zweites Modul zum Anlegen von Zuständen und/oder Lesen von Zuständen von Eingangs-/Ausgangszellen (110) mittels der Boundary Scan Chain (120) der Schaltung gleichzeitig mit der Aktion des ersten Moduls umfaßt.

17. Testgerät für integrierte Schaltungen nach Anspruch 16, **dadurch gekennzeichnet, daß** es zum gleichzeitigen Eingeben von Steuersignalen (SI) von Speicherstellen (140) und von Steuersignalen (SI) von Eingängen/Ausgängen (110) der Boundary Scan (120) in eine integrierte Schaltung vorgesehen ist.

18. Testgerät nach Anspruch 17, **dadurch gekennzeichnet, daß** es zum Eingeben der Steuersignale (51) der Speicherstellen (140) und der Steuersignale (51) der Eingänge/Ausgänge (110) der Boundary Scan (120) in den gleichen Kanal vorgesehen ist.

19. Testgerät nach einem der Ansprüche 16 bis 18, **dadurch gekennzeichnet, daß** es eine Reihe von Kanälen umfaßt, die geeignet sind, direkt mit Eingängen/Ausgängen (103) einer integrierten Schaltung verbunden zu werden, und ein Modul, das geeignet ist, ausgewählte Signale direkt in einige dieser Eingänge/Ausgänge (103) einzugeben und/oder Ausgangssignale von diesen Eingängen/Ausgängen (103, 109) zu empfangen, um diese Ausgangssignale mit erwarteten Signalen zu vergleichen.

20. Testgerät nach Anspruch 19, **dadurch gekennzeichnet, daß** es eine Steuervorrichtung der Boundary Scan Chain (120) einer integrierten Schaltung, die dem Direkt-Eingabe/Empfang-Modul zugeordnet ist, aufweist, um Teetvektoren auf Mengen zu erzeugen, die zugleich mit dem Testgerät direkt verbundene Eingänge-Ausgänge (103) und zugleich mit dem Testgerät über die Boundary Scan Chain (120) verbundene Eingänge-Ausgänge (105) umfassen.

21. Testgerät nach einem der Ansprüche 16 bis 20, **dadurch gekennzeichnet, daß** es geeignet ist, die Menge der Speicherstellen (140) derart zu steuern, daß sich die Funktion der integrierten Schaltung auf eine kombinatorische Funktion während des Test reduziert.
